**Europäisches Patentamt**

**European Patent Office**

**Office européen des brevets**

(19)

(11) Veröffentlichungsnummer: **0 180 723 B1**

(12) **EUROPÄISCHE PATENTSCHRIFT**

(45) Veröffentlichungstag der Patentschrift: **10.04.91**

(51) Int. Cl.⁵: **H01J 37/04, H01J 37/28**

(21) Anmeldenummer: **85109683.4**

(22) Anmeldetag: **01.08.85**

(54) **Korpuskularstrahlgerät.**

(30) Priorität: **13.08.84 DE 3429804**

(43) Veröffentlichungstag der Anmeldung:
**14.05.86 Patentblatt 86/20**

(45) Bekanntmachung des Hinweises auf die
Patenterteilung:
**10.04.91 Patentblatt 91/15**

(84) Benannte Vertragsstaaten:
**DE FR GB NL**

(56) Entgegenhaltungen:
FR-A- 2 153 046
GB-A- 2 052 147
US-A- 3 760 180

PATENTS ABSTRACTS OF JAPAN, Band 5,
Nr. 99 (E-63)[771]; & JP - A - 56 42 946
(TOKYO SHIBAURA DENKI K.K.) 21.04.1981

OPTICAL ENGINEERING, Band 22, Nr. 2,
März/April 1983, Seiten 195-198, Bellingham,
Washington, US; K.J. POLASKO et al.: "Low
energy electron beam lithography"

EXTENDED ABSTRACTS, Band 82-1, Mai
1982, Seiten 503-504, Pennington, New Yersey, US; Y.W. YAU et al.: "The space charge
effects in conventional and in retarding field
electron beam systems"

(73) Patentinhaber: **ICT Integrated Circuit Testing
Gesellschaft für Halbleiterprüftechnik mbH
Klausnerring 1a
W-8011 Heimstetten(DE)**

(72) Erfinder: **Feuerbaum, Hans-Peter, Dr.
Dipl.-Phys.
Arno-Assmann-Strasse 14
W-8000 München 83(DE)**
Erfinder: **Frosien, Jürgen, Dr. Dipl.-Ing.
An der Ottosäule 18
W-8012 Ottobrunn(DE)**
Erfinder: **Spehr, Rainer, Dr.
Erfurter Strasse 19
W-6105 Ober-Ramstadt(DE)**

(74) Vertreter: **Tetzner, Volkmar, Dr.-Ing. Dr. jur.
Van-Gogh-Strasse 3
W-8000 München 71(DE)**

## Beschreibung

Die Erfindung betrifft ein Korpuskularstrahl gerät nach dem Oberbegriff des Anspruchs 1.

Zur Inspektion von mikroelektronischen Bauelementen oder von Gegenständen, die bei der Herstellung von mikroelektronischen Bauelementen benötigt werden, z.B. zur Inspektion von Masken und Wafern, werden in der Halbleiterindustrie bei der Herstellung von integrierten Bauelementen zunehmend Rasterelektronenmikroskope eingesetzt. Die Verwendung eines Rasterelektronenmikroskops in der Elektronenstrahlmeßtechnik ist beispielsweise aus der US-A-4 277 679 bekannt. Die Verwendung eines Rasterelektronenmikroskops zur Erzeugung von Mikrostrukturen mittels Elektronenstrahllithografie ist beispielsweise aus der US-A-4 075 488 bekannt. Darüber hinaus kann ein Rasterelektronenmikroskop auch zur Kontrolle der einzelnen Prozeßschritte bei der Herstellung eines integrierten elektronischen Bauelementes verwendet werden, beispielsweise um Längenabmessungen oder die Positionierung von Maske oder Wafer zu überprüfen.

Bei meßtechnischen Anwendungen eines Rasterelektronenmikroskops, wie beispielsweise bei der Messung von räumlichen Abmessungen oder bei der Messung von Potentialen, muß darauf geachtet werden, daß nicht durch Aufladung der Oberfläche des Meßobjekts die Meßergebnisse verfälscht werden. Um eine Aufladung einer Oberfläche eines Meßob jekts zu vereiden, kann die Oberfläche des Meßobjekts durch Bedampfen mit leitfähigem Material leitfähig gemacht werden. Bei solchen Anwendungen, wo wegen weiterer Verarbeitung des zu überprüfenden Meßobjekts eine Bedampfung der Oberfläche mit leitfähigem Material nicht möglich ist, wie dies z.B. bei Meßobjekten in der Mikroelektronik der Fall ist, ist es erforderlich, daß die Primärelektronen mit solchen Energien auf die Oberfläche des Meßobjekts auftreffen, daß im zeitlichen Mittel genau soviele Ladungen die Oberfläche des Meßobjekts verlassen, wie auf diese Oberfläche auftreffende Ladungen in dieser Oberfläche steckenbleiben. Solche Auftreffenergien der Primärelektronen, bei denen die Ladungsbilanz von auf die Oberfläche auftreffenden und von die Oberfläche verlassenden Ladungen ausgeglichen ist, sind im allgemeinen relativ niedrig und liegen typisch im Bereich von etwa 500 eV bis 2 keV. Bei speziellen Betriebsweisen, bei denen nur im zeitlichen Mittel die Ladungsbilanz ausgeglichen sein muß, oder bei besonderen Materialien, aus denen das Meßobjekt besteht, kann auch bei Auftreffenergien der Primärelektronen bis zu 10 keV und darüber noch eine ausgeglichene Ladungsbilanz an der Oberfläche eines Meßobjekts erzielt werden, so daß eine Aufladung dieser Oberfläche vermieden wird.

Bei Elektronenstrahlschreibern werden heute Auftreffenergien der Primärkospuskeln auf die Oberfläche eines Objekts in der Größenordnung von etwa 20 keV verwendet. Dabei ist eine Tendenz dahingehend zu beobachten, daß in Zukunft bei Elektronenstrahlschreibern eher kleinere Auftreffenergien der Primärkorpuskeln verwendet werden. Je geringer die Auftreffenergie der Primärkorpuskeln beim Auftreffen auf ein Objekt ist, desto kleiner ist der Proximity-Effekt, desto kleiner ist das Streuvolumen im Fotolack (resist) und im Target. Man wird also auch bei Korpuskularstrahlscbreibern in Zukunft immer feinere Korpuskularstrahlsonden mit immer höherem Korpuskularstrahlstrom bei immer kleineren Auftreffenergien benötigen. Je niedriger die Energie der Korpuskeln im Korpuskularstrahlengang ist, desto niedriger ist bei konventionellen Rasterelektronenmikroskopen die Auflösung bei Messungen, desto größer ist der Durchmesser der auf das Objekt auftreffenden Korpuskularsonde und desto kleiner ist der Korpuskularsondenstrom. Konventionelle Rasterelektronenmikroskope sind daher für die genannten Anwendungsbereiche nicht optimal nutzbar. Die Ursache für diese Nachteile bei konventionellen Rasterelektronenmikroskopen ist der sogenannte Boersch-Effekt (H.Rose, R.Spehr, Advances in Electronics and Electron Physics, Supplement 13c, Seiten 475 ff. (1983)), der einer Fokussierung der Korpuskeln im Korpuskularstrahl entgegenwirkt. Der Richtstrahlwert (brightness) speziell von intensitätsstarken Korpuskularquellen (wie z.B. Lanthanhexaborid-Einkristallkathoden zur Erzeugung von Elektronenstrahlen) kann daher nicht voll genutzt werden. Besonders bei niedrigen Energien der Korpuskeln nimmt der Richtstrahlwert, bedingt durch den Boersch-Effekt, auf dem Weg von der Korpuskularquelle zum Objekt, auf das die Korpuskeln auftreffen, ab. Bei einem Elektronenstrahl mit einer Energie der Elektronen von 1 keV kann der Verlust beim Richtstrahlwert auf dem Weg von der Elektronenquelle zum Objekt den Faktor 20 übersteigen. Bei niedriger Energie der Korpuskeln werden die Überkreuzungspunkte der Korpuskularstrahlen, die im Strahlengang hinter den verschiedenen Linsen liegen, unter Umständen erheblich verbreitert, was zur Verbreiterung der Korpuskularsonde, zur Verschlechterung einer meßtechnischen Auflösung und zur Verringerung der Korpuskularstromdichte führt.

Aus der DE-A-31 38 926 ist ein Elektronenmikroskop zur Erzeugung von Hochstromsonden mit einer einstufigen Sondenformung und mit einer kurzbrennweitigen Abbildungslinse bekannt. Weil H.Rose et al in "Optik" 57 (1980), No.3, Seite 339, gezeigt haben, daß die Energieverbreiterung des Primärelektronenstrahls proportional mit der Zahl der Elektronenstrahl-Überkreuzungspunkte ansteigt, wird bei einem Elektronenmikroskop nach dieser deutschen Offenlegungsschrift der Boersch-Effekt verkleinert. Ein solches bekanntes Elektronenmikroskop ist jedoch nicht für Anwendungen geeignet, bei denen ein großer Arbeitsabstand benötigt wird, oder bei denen ein Austastsystem benötigt wird, das in einem Strahlüberkreuzungspunkt angeordnet ist, das relativ einfach zugänglich ist und das einen relativ großen Abstand zu einem Objekt aufweisen muß, damit schädliche Einwirkungen von den im Austastsystem geführten Potentialen auf das Objekt vermieden werden.

Aus der DE-A-32 04 897 ist ein korpuskularstrahlerzeugendes System bekannt, das als Tetrode ausgebildet ist. Ein Teilsystem dieses korpuskularstrahlerzeugenden Systems, das aus Kathode, Wehnelt-Elektrode und Anode besteht, wird dabei für eine bestimmte Korpuskularstrahlenergie so eingestellt, daß optimale Feldstärken und damit ein optimaler Richtstrahlwert erzielt werden. Um unterschiedliche Korpuskularstrahlenergien zu erhalten, ist die Potentialdifferenz zwischen diesem Teilsystem und der zusätzlichen nachgeschalteten Elektrode auf unterschiedliche Werte einstellbar. Auf diese Weise wird im korpuskularstrahlerzeugenden System ein Korpuskularstrahl mit einem optimalen Richtstrahlwert und einer gewünschten Korpuskularstrahlenergie erzeugt. Bei diesem bekannten Korpuskularstrahlerzeuger kann je doch nicht verhindert werden, daß der unmittelbar hinter dem Korpuskularstrahlerzeuger vorhandene optimale Richtstrahlwert im weiteren Korpuskularstrahlengang aufgrund des Boersch-Effekts verschlechtert wird.

Aus Optical Engineering Band 22 Nr. 2, März/April 1983, Seiten 195 bis 198 ist ein Elektronenstrahlschreiber bekannt, in dem die auf eine hohe Energie beschleunigten Primärelektronen in einem oberhalb der zu strukturierenden Probe aufgebauten elektrischen Feld auf die gewünschte Endenergie abgebremst werden. Die auf einem negativen Potential liegende Probe ist hierbei so relativ zur Objektivlinse angeordnet, daß sich das elektrische Verzögerungsfeld unmittelbar an das fokussierende Magnetfeld anschließt bzw. sich diesem teilweise überlagert.

In den aus JP-A-56 42 946 und GB-A-20 52 147 bekannten Rasterelektronenmikroskopen wird die Elektronenenergie mit Hilfe einer unterhalb der elektronenoptischen Säule angeordneten Elektrode eingestellt.

Der vorliegenden Erfindung liegt die Aufgabe zugrunde, ein Korpuskularstrahlgerät der eingangs genannten Art anzugeben, bei dem die Auswirkungen des Boersch-Effekts kleiner sind als in bekannten Geräten.

Diese Aufgabe wird erfindungsgemäß durch ein Korpuskularstrahlgerät nach Patentanspruch 1 gelöst. Ausgestaltungen und Vorteile der Erfindung sind in den Unteransprüchen, der Beschreibung und der Zeichnung dargestellt.

Das erfindungsgemäße Korpuskularstrahlgerät ist nicht nur zur Erzeugung von Elektronenstrahlen, sondern auch zur Erzeugung von beliebigen Ionenstrahlen geeignet. Das erfindungsgemäße Korpuskularstrahlgerät ermöglicht eine feine Korpuskularsonde mit hohem Korpuskularstrom auch bei kleinen Auftreffenergien der Korpus keln auf ein Objekt. Bisher wurde angenommen, daß der Boersch-Effekt eine wichtige Rolle nur im Korpuskularstrahlerzeuger und in den Strahlüberkreuzungspunkten (Foci) spielt. Neue Rechnungen haben gezeigt, daß der Boersch-Effekt eine wichtige Rolle nicht nur im Korpuskularstrahlerzeuger und in den Strahlüberkreuzungsbereichen (cross-overs), sondern auch im gesamten Strahlengang spielt. Durch den Boersch-Effekt wird der Richtstrahlwert, wie er unmittelbar hinter dem Strahlerzeuger gegeben ist, im weiteren Korpuskularstrahlengang verkleinert. Je länger dieser Korpuskularstrahlengang ist, desto stär ker sind die nachteiligen Auswirkungen des Boersch-Effekts. Bei Verwendung einer Lanthanhexaborid-Einkristallkathode und bei einer Auftreffenergie der Elektronen von 1 keV auf eine Probe wird der Richtstrahlwert aufgrund des Boersch-Effekts im unveränderten Korpuskularstrahlengang eines Rasterelektronenmikroskops der Fa. Cambridge Instruments vom Typ S 150 um den Faktor 40 verschlechtert. Wenn dagegen der Korpuskularstrahlengang desselben Rasterelektronenmikroskops vom Typ S 150 in erfindungsgemäßer Weise verändert wird, wenn dabei die Elektronen bis zur Mitte der Objektivlinse eine Energie von 20 keV besitzen und wenn sie erst in dieser Mitte der Objektivlinse auf die Auftreffenergie von 1 keV abgebremst werden, verschlechtert sich unter sonst gleichen Randbedingungen der Richtstrahlwert nur noch um den Faktor 4. Dies bedeutet gegenüber einem Rasterelektronenmikroskop nach dem Stand der Technik einen Gewinn beim Richtstrahlwert um den Faktor 10. Besitzen in einem anderen Beispiel beim selben Rasterelektronenmikroskop S 150 die Elektronen bis zur Mitte der Objektivlinse eine Energie von 10 keV und werden erst in dieser Mitte der Objektivlinse die Elektronen auf die Auftreffenergie von 1 keV abgebremst, so ist der Richtstrahlwert in Höhe des Objekts um einen Faktor 5,5 schlechter als der Richtstrahlwert unmittelbar hinter der Elektronenquelle. Dies bedeutet in diesem Beispiel einen Gewinn des Richtstrahlwertes in Höhe des Objekts gegenüber dem Stand der Technik um einen Faktor von ungefähr 7.

Besitzen in einem weiteren Beispiel beim selben Rasterelektronenmikroskop die Elektronen vom Verlassen des Strahlerzeugers bis zur Mitte der Objektivlinse eine Energie von 5 keV und werden dann in dieser Mitte der Objektivlinse auf die Auftreffenergie von 1 keV abgebremst, so ist in Höhe des Objekts der Richtstrahlwert um den Faktor 10 schlechter als unmittelbar hinter der Elektronenquelle. Dies bedeutet in diesem Fall einen Gewinn beim Richtstrahlwert in Höhe des Objekts gegenüber dem Stand der Technik um einen Faktor 4.

Besitzen die Elektronen beim selben Rasterelektronenmikroskop S 150 zwischen der Elektronenquelle und der Mitte der Objektivlinse eine Energie von 2,5 keV und werden die Elektronen erst in dieser Mitte der Objektivlinse auf die Auftreffenergie von 1 keV abgebremst, so ist der Richtstrahlwert in Höhe des Objekts um den Faktor 18 schlechter als der Richtstrahlwert unmittelbar hinter der Elektronenquelle. Dies bedeutet jedoch immer noch einen Gewinn beim Richtstrahlwert gegenüber dem Stand der Technik um einen Faktor von etwa 2,2.

Je näher ein Abbremspunkt bei sonst unveränderten Parametern an der Probe ist, umso größer ist der Gewinn beim Richtstrahlwert. Je näher ein Abbremspunkt bei sonst unveränderten Parametern an der Korpuskularquelle ist, umso geringer ist der Gewinn, der beim Richtstrahlwert erzielt wird.

Bei einem einstufigen Korpuskularstrahlengang, das nur eine einzige Linse und damit nur einen einzigen Crossover aufweist, wird der Abbremspunkt für die Korpuskeln in der einzigen Linse angeordnet.

Bei einem zweistufigen Korpuskularstrahlengang, bei dem also zwei Linsen vorhanden sind, wird ein großer Gewinn für den Richtstrahlwert dann erzielt, wenn der Abbremspunkt im zweiten Crossover angeordnet ist. Bei einem n-stufigen Korpuskularstrahlengang mit n-Linsen kann ein Abbremspunkt vorteilhafterweise im n-ten Crossover oder in einem der vorhergehenden Crossovers angeordnet sein. Wenn nur der Gewinn für den Richtstrahlwert von Bedeutung ist, so ist es am vorteilhaftesten, wenn bei einem n-stufigen System ein einziger Abbremspunkt im n-ten Crossover angeordnet ist und wenn gegebenenfalls zusätzlich ein Austastsystem (beam-blanking system) im selben Crossover vorgesehen ist.

Je nach Anwendungsfall kann es günstig sein, mehrere Abbremseinrichtungen vorzusehen. Dies hängt davon ab, welche zusätzlichen Einrichtungen im Korpuskularstrahl untergebracht werden müssen, wie groß der Arbeitsabstand zu sein hat, ob das Objekt durch hohe Potentiale in der Nähe dieses Objekts in seiner Funktion bzw. in seinem Aufbau beeinträchtigt wird, ob die Abbremseinrichtungen zugleich auch linsenähnliche Eigenschaften haben oder in Linsen integriert sind und somit bei ihrer Ausgestaltung ihr Einfluß auf den gesamten Strahlengang mit berücksichtigt werden muß.

Falls beispielsweise ein großer Arbeitsabstand erforderlich ist, genügt im allgemeinen eine einzige Linse nicht. Für den Einbau eines Austastsystems, das zum Austasten mit einem bezüglich des Potentials der Probe stark unterschiedlichen Potential beaufschlagt werden muß, wird beispielsweise ein leicht zugänglicher Überkreuzungspunkt im Korpuskularstrahlengang benötigt, der zusätzlich noch einen bestimmten Mindestabstand zur Probe aufweisen muß.

Im einfachsten Fall besteht eine Einrichtung zum Abbremsen der Korpuskel im Korpuskularstrahlengang aus einem oder mehreren Netzen, die mit bestimmten Spannungen beaufschlagt werden. Eine Netzelektrode bzw. eine Gitterelektrode hat in erster Näherung keine Linsenwirkung, sofern die das Netz bzw. das Gitter bildenden Elemente keine großen Abstände voneinander aufweisen. Um im Korpuskularstrahlengang einfache Potentialverteilungen zu haben, ist es zweckmäßig, zwei Netzelektroden unmittelbar hintereinander anzuordnen, wobei die zweite Netzelektrode als retardierende Elektrode verwendet wird. Es kann jedoch auch eine einzelne Netzelektrode verwendet werden, sofern die dann kompliziertere Potentialverteilung bei der Ausgestaltung der übrigen Einrichtungen im Korpuskularstrahlengang berücksichtigt wird. Dies gilt nicht nur für Netzelektroden, sondern auch für alle anderen Einrichtungen, die zum Abbremsen der Korpuskel verwendet werden können.

Grundsätzlich kann jedes elektrostatische Verzögerungselement zum Abbremsen der Korpuskel verwendet werden. Insbesondere können zwei oder mehr Elektrodenanordnungen benutzt werden. Als Einrichtungen zum Abbremsen mit Linsenwirkungen können Blenden, Rohrlinsen oder Bremslinsen (Einzellinse) oder Kombinationen daraus und zusammen mit Netzelektroden verwendet werden. Elektrostatische Linsen können dabei zusätzlich zu magnetischen Linsen oder anstelle von magnetischen Linsen vorgesehen werden.

Vorteilhaft ist eine elektronenoptisch günstige Kombination eines elektrostatischen Abbremssystems mit einer Objektivlinse. In einer elektrostatischen Immersionsobjektivlinse kann eine Einrichtung zum Abbremsen mit einer Objektivlinse kombiniert werden. Damit ist gleichzeitig ein hoher Richtstrahlwert in Höhe des Objekts und eine feine Sonde auf dem Objekt möglich.

Die Erfindung kann auch für Elektronenstrahlschreiber verwendet werden. Beispielsweise können die Elektronen bis zum Abbremspunkt eine Energie von 50 keV besitzen und sodann auf die normale Auftreffenergie, beispielsweise 20 keV, abgebremst werden. Damit wird eine feine Sonde mit sehr hohem Strahlstrom bei relativ kleinen Auftreffenergien erzielt. Bei immer feineren Strukturen, bei immer größerer Schreibgeschwindigkeit und bei Kathoden mit immer größerem Richtstrahlwert der Strahlerzeuger wird das Merkmal eines sehr hohen Sondenstromes in Zukunft immer wichtiger sein.

Es muß ein Optimum zwischen elektronenoptischen Linseneffekten und den Effekten hinsichtlich des Richtstrahlwertes in Höhe des Objekts gefunden werden. Falls eine bereits vorhandene Objektivlinse in einem Korpuskularstrahlengang ungünstige Eigenschaften aufweist, muß die Einrichtung zum Abbremsen der Korpuskeln im Strahlengang weiter zurückgelegt werden.

Um nur kleine Linsenfehler in Kauf nehmen zu müssen, sollen möglichst wenig zusätzliche Linseneffekte in den Korpuskularstrahlengang eingebracht werden. Zu diesem Zweck wird am zweckmäßigsten eine Netzelektrode in einen Crossover eingesetzt.

Je langsamer sich die Korpuskel im Korpuskularstrahlengang bewegen, desto nachteiliger sind die Wirkungen des Boersch-Effekts.

Um im Korpuskularstrahlengang geringe Farbfehler zu erhalten, soll die Energieverbreiterung der Korpuskel vor dem Abbremspunkt gering sein. Daher sollen vor dem Abbremspunkt nicht zu hohe Spannungen verwendet werden. Da für sind bei Elektronen Beschleunigungsspannungen vor dem Abbremspunkt zwischen etwa 5 keV und 15 keV wünschenswert. Dies hängt aber von den verwendeten elektronenoptischen Linsen und von den Anwendungsbedingungen ab. Hier spielt die Sondengröße eine ähnliche Rolle wie bei der Suche nach einer optimalen Apertur für eine bestimmte Sondengröße, d.h., daß es für eine bestimmte Sondengröße eine optimale Beschleunigungsspannung vor dem Abbremspunkt gibt. Diese optimale Beschleunigungsspannung kann von einem Fachmann auch experimentell ermittelt werden.

Falls der Abbremspunkt aus elektrostatischen Gründen relativ weit entfernt vom Objekt angeordnet werden muß, sollte nach Möglichkeit die Verkleinerung der Objektivlinse nicht so stark sein, damit die Länge des Korpuskularstrahlenganges insgesamt kurz gehalten werden kann. Je kürzer nämlich der Strahlengang ist, desto geringer sind die nachteiligen Effekte aufgrund des Boersch-Effekts. Daher soll das Niederspannungsstück eines Rasterelektronenmikroskops hinter dem Abbremspunkt so kurz wie möglich sein. Daher soll die Verkleinerung in diesem Niederspannungsstück so gering wie möglich sein. Wenn die Verkleinerung in diesem Niederspannungsbereich beispielsweise statt 6-fach nur 3-fach ist, wird beim Richtstrahlwert ein Gewinn um einen Faktor 1,5 erzielt.

Ausführungsbeispiele der Erfindung sind in der Zeichnung dargestellt und werden im folgenden näher beschrieben.

Fig.1 mit 5 zeigen Niederspannungs-Rastermikroskope mit Elektronenabbremsung.

Fig.6 zeigt verschiedene Einrichtungen zum Abbremsen des Primärelektronenstrahles.

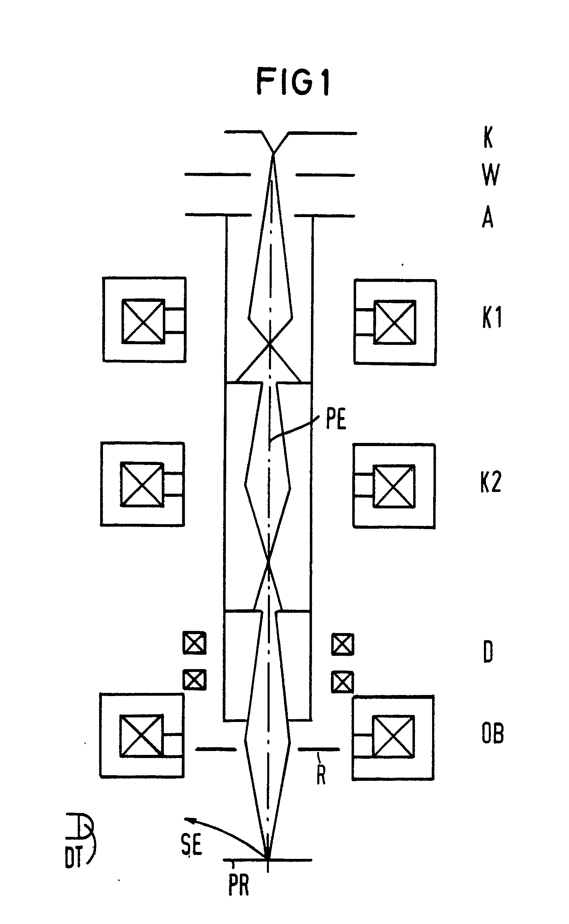

In einem Niederspannungs-Rastermikroskop nach den Fig.1 mit 5 werden die Elektronen PE überwiegend auf relativ hohem Potential geführt. Für meßtechnische Zwecke sollen die Elektronen PE beispielsweise mit einer Energie von 1 keV auf die Oberfläche der Probe PR auftrffen. In diesem Fall besitzen die Elektronen PE vor der Abbremselektrode R beispielsweise eine Energie oberhalb von 2 keV, vorteilhaft oberhalb von 4 keV, insbesondere oberhalb von 10 keV oder 20 keV. Dabei werden die Elektronen PE innerhalb der Objektivlinse OB auf die gewünschte, niedrige Auftreffenergie abgebremst. Hierdurch wird erreicht, daß die Auswirkungen des Boersch-Effekts stark reduziert werden. Besonders im Bereich der ersten Kondensorlinse K2 und im Bereich der zweiten Kondensorlinse K1, wo noch hohe Elektronenstromdichten vorhanden sind, sollen relativ hohe Energien der Primärelektronen verwendet werden, da in diesen Bereichen ein wesentlicher Anteil der Verschlechterung des Richtstrahlwertes eintritt.

In den Fig.1 mit 5 liegen die Kathode K auf einem Potential von -1 kV, die Wehnelt-Elektrode W auf einem Potential von etwa -1,5 kV und die Anode A auf einem Potential von +19 kV.

Die Primärelektronen PE laufen zunächst mit hoher Energie im Strahlengang. Erst kurz vor Erreichen der Probe PR oder nach Durchlaufen wenigstens einer Kondensorlinse werden die Primärelektronen PE auf die gewünschte niedrige Auftreffenergie abgebremst. Dabei werden mindestens ein Teil des Strahlenganges sowie die kritischen Strahlüberkreuzungspunkte (Foci) mit hoher Energie durchlaufen. Auf diese Weise wird die auflösungsbeeinträchtigende Wirkung des Boersch-Effekts erheblich vermindert.

Im Ausführungsbeispiel nach Fig.1 besitzen die Elektronen PE fast im gesamten Strahlengang eine hohe Primärelektronenenergie und werden erst in der Objektivlinse OB abgebremst. Die Abbremselektrode R liegt dabei auf einem Potential von 0 V. Sekundärelektronen SE, die am Auftreffort der Primärelektronen PE auf der Probe PR ausgelöst werden, können für meßtechnische Zwecke über einen Detektor DT nachgewiesen werden. Als Ablenkeinrichtungen zum Rastern der Sonde der Primärelektronen PE dienen die Ablenkspulen D.

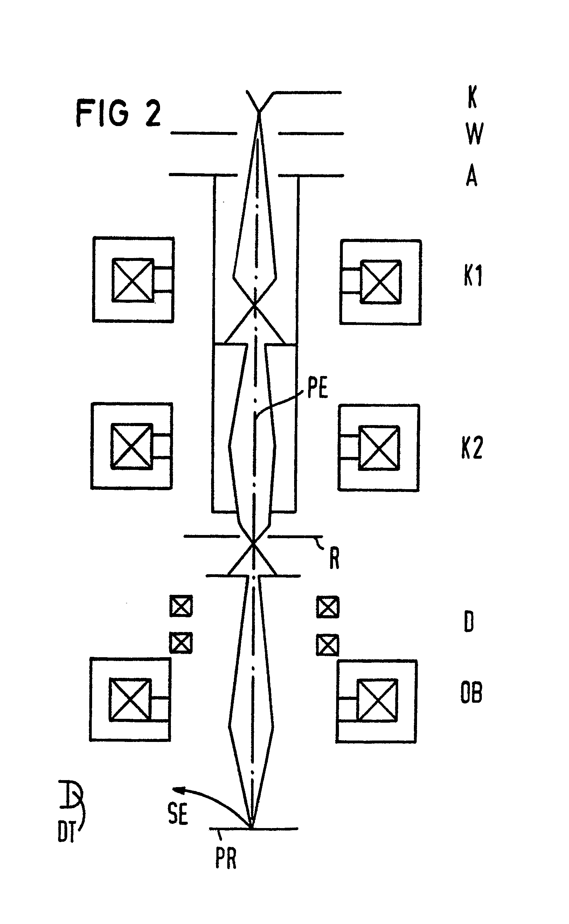

Im Niederspannungs-Rastermikroskop nach Fig.2 werden die Primärelektronen PE zwischen der ersten Kondensorlinse K2 und der Objektivlinse OB abgebremst. Besitzt ein Rasterelektronenmikroskop nur eine einzige Kondensorlinse, so wird in einem analogen Ausführungsbeispiel die Abbremselektrode R zwischen dieser einzigen Kondensorlinse und der Objektivlinse dieses Rasterelektronenmikroskops angeordnet.

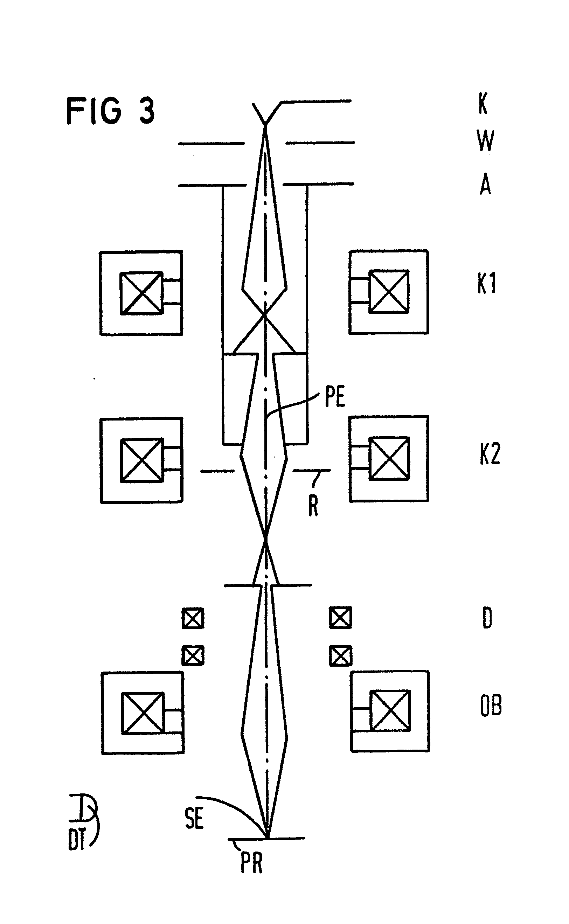

Im Niederspannungs-Rastermikroskop nach Fig.3 werden die Primärelektronen PE in der Kondensorlinse K2 abgebremst. In diesem Fall ist die Abbremselektrode R in der Kondensorlinse K2 angeordnet.

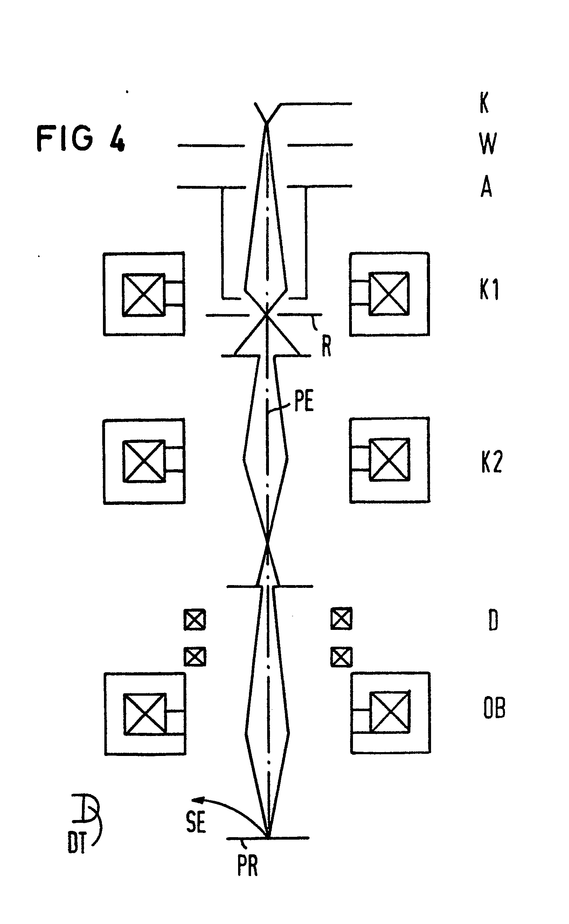

Die Ausführungsformen nach Fig.2 und nach Fig.3 haben den Vorteil, daß ein Quellenbild (Crossover), das auf Massepotential (0 kV) liegt, zugänglich ist. Die Abbremselektrode R weist in den Ausführungsbeispielen nach Fig. 1 mit 4 jeweils das Potential 0 kV auf. Um das Potential für die Elektronen PE besser zu definieren, bewegen sich die Elektronen PE bis unmittelbar vor der Abbremselektrode R in einem Rohr aus nicht-ferromagnetischem Material, welches das Potential der Anode A aufweist. Die ses Rohr ist am längsten in Fig.1, kürzer in Fig.2, noch kürzer in Fig.3 und am kürzesten in Fig.4.

Wo das Quellenbild auf Massepotential zugänglich ist, kann vorteilhafterweise ein Austastsystem angeordnet werden.

In den Ausführungsbeispielen nach den Figuren 1 mit 4 werden Abbildungsfehler, die beim Abbremsen der Elektronen PE entstehen, bei der optischen Verkleinerung durch die Objektivlinse OB mit verkleinert.

Im Niederspannungs-Rastermikroskop nach Fig.4 werden die Elektronen PE zwischen der Kondensorlinse K1 und der Kondensorlinse K2 abgebremst. Dabei ist die Abbremselektrode R in demjenigen Strahlüberkreuzungspunkt angeordnet, der zur Kondensorlinse K1 gehört. Bei diesem Ausführungsbeispiel nach Fig.4 ist die den Einfluß des Boersch-Effekts hemmende Wirkung allerdings geringer als bei den vorhergehenden Ausführungsbeispielen.

Weist ein Rasterelektronenmikroskop mehr als zwei Kondensorlinsen auf, so können Abbremselektroden R analog zu den Ausführungsbeispielen nach den Fig.1 bis 4 auch dort zwischen je zwei aufeinanderfolgenden Kondensorlinsen oder innerhalb einer Kondensorlinse oder in einer Objektivlinse angeordnet werden. Auch bei einem Rasterelektronenmikroskop mit einer Feldemissionskathode kann eine Abbremselektrode R verwendet werden. Hierbei ist eine Abbremsung der Primärelektronen PE vor der Objektivlinse OB am geeignetsten.

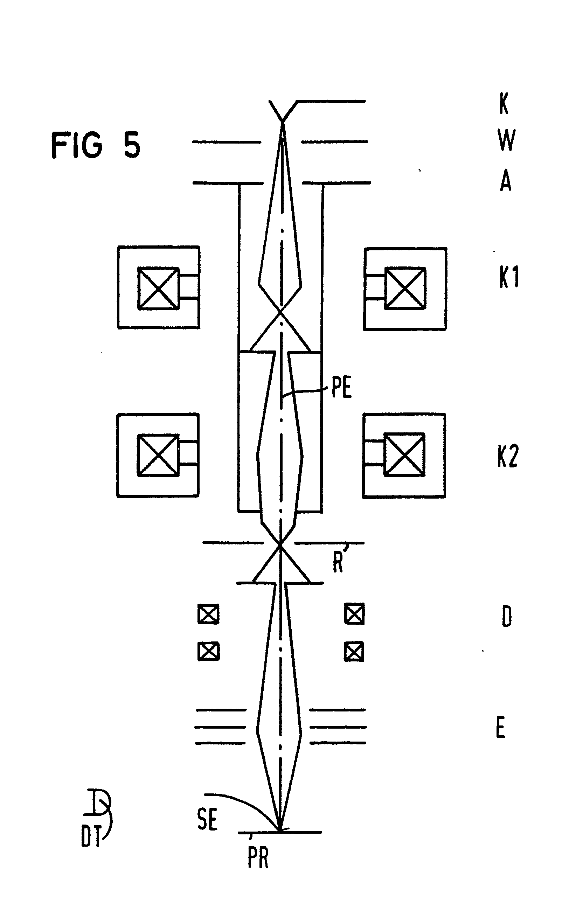

Fig.5 zeigt ein Niederspannungs-Rastermikroskop mit einer Kondensorlinse K1, mit einer Abbremselektrode R in nerhalb dieser Kondensorlinse K1 und mit einer Einzellinse E als Immersionslinse anstelle der Objektivlinse OB, wie sie in den Beispielen nach den Fig.1 mit 4 vorgesehen ist. Bei dieser Einzellinse E weist die der Probe PR am nächsten gelegene Elektrode ein Potential U3 auf, das kleiner ist als das Potential U1 der - im Strahlengang gesehen - ersten Elektrode dieser Einzellinse E. Vorteilhafterweise kann diese Einzellinse E auch so ausgestaltet werden, daß sie zusätzlich noch als Korpuskularstrahl-Austastsystem verwendet werden kann. Eine solche Einzellinse E ist aus der US-A-4 439 685 bekannt.

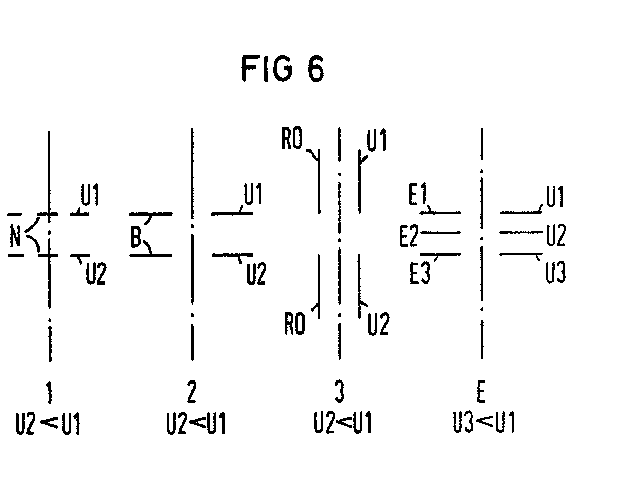

Fig.6 zeigt verschiedene Beispiele für Einrichtungen zum Abbremsen der Primärelektronen PE. Zur Abbremsung der Primärelektronen PE können jegliche elektrostatische 2- oder Mehr-Elektrodenanordnungen oder Kombinationen daraus verwendet werden. Beispielsweise kann eine 2-Elektrodenanordnung 1 aus zwei hintereinandergeschalteten Netzen N verwendet werden, wobei das der Probe PR nächstgelegene Netz N ein kleineres Potential aufweist als das der Probe PR weiter entfernt gelegene Netz. Weiter kann eine 2-Elektrodenanordnung 2 verwendet werden, bei der zwei Blenden B hintereinander angeordnet sind. Diese Anordnung 2 hat linsenähnliche Eigenschaften.

Weiter kann eine 2-Elektrodenanordnung 3 verwendet werden, die aus zwei hintereinander angeordneten Rohren RO besteht. Das Potential U2 des der Probe PR nächstgelegenen Rohres RO ist dabei wiederum kleiner als das Potential U1 desjenigen Rohres RO, das von der Probe PR weiter entfernt angeordnet ist.

Weiter kann zum Abbremsen der Primäelektronen PE eine Einzellinse E verwendet werden. Um eine Abbremswirkung zu erzielen, ist das Potential U3 der der Probe PR nächstgelegenen Elektrode E3 kleiner als das Potential U1 der der Probe PR am weitesten entfernt gelegenen Elektrode E1. Zum Austasten der Primärelektronen PE erhält die mittlere Elektrode E2 der Einzellinse E ein gegenüber dem Potential U1 sehr stark negatives Potential U2. Bei der aus der US-A-4 439 685 bekannten Einzellinse sind die Potentiale der beiden äußeren Elektroden gleich groß, wodurch keine abbremsende Wirkung auf die Primärelektronen PE erzielt wird.

## Ansprüche

1. Korpuskularstrahlgerät mit einem Korpuskularstrahlerzeuger (K,W,A), mit einer korpuskularoptischen Einheit, die mindestens eine Kondensorlinse (K1, K2), ein Ablenksystem (D) und eine Objektivlinse (OB) zur Fokusierung des Korpuskularstrahls auf eine Probe (PR) aufweist, und mit einer Verzögerungseinrichtung (R) zum Abbremsen der Korpuskeln (PE), **dadurch gekennzeichnet,** daß die Verzögerungseinrichtung, (R) innerhalb der korpuskularoptischen Einheit angeordnet ist und das Gerät Mittel enthält zur Beaufschlagung der Verzögerrungseinrichtung (R) mit einem derartigen Potential, daß die Korpuskeln (PE) von einer ersten Energie im Bereich von 2 bis 50 keV auf eine niedrigere zweite Energie im Bereich von 0.5 bis 20 keV abgebremst werden.

2. Korpuskularstrahlgerät nach Anspruch 1, dadurch **gekennzeichnet** daß die Kondensorlinse (K1,K2) eine magnetische Linse ist.

3. Korpuskularstrahlgerät nach Anspruch 1 oder 2, **dadurch gekennzeichnet**, daß die Verzögerungseinrichtung (R) zwischen einer ersten (K1) und einer zweiten Kondensorlinse (K2) angeordnet ist.

4. Korpuskularstrahlgerät nach einem der Ansprüche 1 oder 2, **dadurch gekennzeichnet,** daß die Verzögerungseinrichtung (R) zwischen einer Kondensorlinse (K1, K2) und der Objektivlinse (OB) angeordnet ist.

5. Korpuskularstrahlgerät nach einem der Ansprüche 1 bis 4, **dadurch gekennzeichnet**, daß die Verzögerungseinrichtung (R) in einem Strahlüberkreuzungspunkt angeordnet ist.

6. Korpuskularstrahlgerät nach Anspruch 1 oder 2, dadurch **gekennzeichnet**, daß die Verzögerungseinrichtung (R) innerhalb der Objektivlinse (OB) angeordnet ist.

7. Korpuskularstrahlgerät nach Anspruch 1 oder 2, **dadurch gekennzeichnet**, daß die Verzögerungseinrichtung (R) innerhalb einer Kondensorlinse (K1, K2) angeordnet ist.

8. Korpuskularstrahlgerät nach einem der Ansprüche 1 bis 7, **gekennzeichnet** durch ein in einem Strahlüberkreuzungspunkt angeordnetes Austastsystem.

9. Korpuskularstrahlgerät nach Anspruch 8, dadurch **gekennzeichnet**, daß das Austastsystem im Strahlengang hinter der Verzögerungseinrichtung (R) angeordnet ist.

10. Korpuskularstrahlgerät nach einem der Ansprüche 1 bis 9, **gekennzeichnet** durch eine elektrische Einzellinse (E) als Objektivlinse (OB).

11. Korpuskularstrahlgerät nach einem der Ansprüche 1 bis 10, **gekennzeichnet durch** einen auf dem Potential der Anode (A) des Korpuskularstrahlerzeugers liegenden Hohlzylinder, der zwischen dem Korpuskularstrahlerzeuger und der Verzögerungseinrichtung (R) koaxial zur Strahlachse angeordnet ist.

12. Korpuskularstrahlgerät nach Anspruch 11, dadurch **gekennzeichnet**, daß der Hohlzylinder aus einem nichtferromagnetischen Material besteht.

13. Korpuskularstrahlgerät nach einem der Ansprüche 1 bis 5, **dadurch gekennzeichnet**, daß der Korpuskularstrahlerzeuger (K, W, A) eine Feldemissionskathode (K) aufweist und daß die Verzögerungseinrichtung (R) im Strahlengang oberhalb der Objektivlinse (OB) angeordnet ist.

14. Korpuskularstrahlgerät nach einem der Ansprüche 1 bis 13, **gekennzeichnet** durch eine elektrostatische Verzögerungseinrichtung (R).

15. Korpuskularstrahlgerät nach einem der Ansprüche 1 bis 14, **gekennzeichnet durch** eine Mehr-Elektrodenanordnung (E) als Verzögerungseinrichtung (R).

16. Korpuskularstrahlgerät nach Anspruch 15, **gekennzeichnet durch** eine Zwei-Elektrodenanordnung (1, 2, 3) als Verzögerungseinrichtung (R).

17. Korpuskularstrahlgerät nach einem der Ansprüche 1 bis 14, **gekennzeichnet durch** eine Netzelektrode (N) als Verzögerungseinrichtung (R).

18. Korpuskularstrahlgerät nach einem der Ansprüche 1 bis 14, **gekennzeichnet durch** eine Blende (B) als Verzögerungseinrichtung (R).

19. Korpuskularstrahlgerät nach einem der Ansprüche 1 bis 14, **gekennzeichnet durch** eine Rohrlinse (RO) als Verzögerungseinrichtung (R).

20. Korpuskularstrahlgerät nach einem der Ansprüche 1 bis 15, **gekennzeichnet durch** eine Einzellinse (E) als Verzögerungseinrichtung (R).

21. Verwendung eines Korpuskularstrahlgeräts nach einem der Ansprüche 1 bis 20 als Korpuskularstrahlmeßgerät.

22. Verwendung eines Korpuskularstrahlgeräts nach einem der Ansprüche 1 bis 20 als Korpuskularstrahlschreiber.

23. Verwendung eines Korpuskularstrahlgeräts nach einem der Ansprüche 1 bis 20 als Längenmeßgerät.

**Claims**

1. Corpuscular beam device with a corpuscular beam generator (K, W, A), with a corpuscular-optical unit which has at least one condenser lens (K1, K2), a deflection system (D) and an objective lens (OB) for focussing the corpuscular beam onto a testpiece (PR), and with a retarding arrangement (R) for retarding the corpuscles (PE), characterised in that the retarding arrangement (R) is arranged within the corpuscular-optical unit and the device contains means for acting upon the retarding arrangement (R) with such a potential that the corpuscles (PE) are retarded from a first energy level in the range from 2 to 50 keV to a lower second energy level in the range from 0.5 to 20 keV.

2. Corpuscular beam device as claimed in claim 1, characterised in that the condenser lens (K1, K2) is a magnetic lens.

3. Corpuscular beam device as claimed in claims 1 or 2, characterised in that the retarding arrangement (R) is arranged between a first (K1) and a second condenser lens (K2).

4. Corpuscular beam device as claimed in one of claims 1 or 2, characterised in that the retarding arrangement (R) is arranged between a condenser lens (K1,K2) and the objective lens (OB).

5. Corpuscular beam device as claimed in one of claims 1 to 4, characterised in that the retarding arrangement (R) is arranged in a beam crossover.

6. Corpuscular beam device as claimed in claim 1 or 2, characterised in that the retarding arrangement (R) is arranged within the objective lens (OB).

7. Corpuscular beam device as claimed in claim 1 or 2, characterised in that the retarding arrangement (R) is arranged within a condenser lens (K1, K2).

8. Corpuscular beam device as claimed in one of claims 1 to 7, characterised by a blanking system arranged in the beam crossover.

9. Corpuscular beam device as claimed in claim 8, characterised in that the blanking system is arranged in the beam path behind the retarding arrangement (R).

10. Corpuscular beam device as claimed in one of claims 1 to 9, characterised by an electric single lens (E) as objective lens (OB).

11. Corpuscular beam device as claimed in one of claims 1 to 10, characterised by a hollow cylinder which lies at the potential of the anode (A) of the corpuscular beam generator and is arranged coaxially with respect to the beam axis between the corpuscular beam generator and the retarding arrangement (R).

12. Corpuscular beam device as claimed in claim 1, characterised in that the hollow cylinder is made from a non-ferromagnetic material.

13. Corpuscular beam device as claimed in one of claims 1 to 5, characterised in that the corpuscular beam generator (K, W, A, ) has a field emission cathode (K) and that the retarding arrangement (R) is arranged in the beam path above the objective lens (OB).

14. Corpuscular beam device as claimed in one of claims 1 to 13, characterised by an electrostatic retarding arrangement (R).

15. Corpuscular beam device as claimed in one of claims 1 to 14, characterised by a multi-electrode arrangement (E) as retarding arrangement (R).

16. Corpuscular beam device as claimed in claim 15, characterised by a two-electrode arrangement (1, 2, 3) as retarding arrangement (R).

17. Corpuscular beam device as claimed in one of claims 1 to 14, characterised by a net electrode (N) as retarding arrangement (R).

18. Corpuscular beam device as claimed in one of claims 1 to 14, characterised by a shutter (B) as retarding arrangement (R).

19. Corpuscular beam device as claimed in one of claims 1 to 14, characterised by a tube lens (RO) as retarding arrangement (R).

20. Corpuscular beam device as claimed in one of claims 1 to 15, characterised by a single lens (E) as retarding arrangement (R).

21. Use of a corpuscular beam device as claimed in one of claims 1 to 20 as a corpuscular beam measuring device.

22. Use of a corpuscular beam device as claimed in one of claims 1 to 20 as a corpuscular beam recording device.

23. Use of a corpuscular beam device as claimed in one of claims 1 to 20 as a length measuring device.

## Revendications

1. Appareil a rayonnement corpusculaire comprenant un générateur d'un faisceau de corpuscules (K,W,A), comportant un dispositif optique pour corpuscules qui comprend au moins une lentille de condenseur (K1,K2), un système d'effacement (D) et une lentille d'objectif (OB) destinée à focaliser le faisceau de corpuscules sur un échantillon (PR), ledit appareil comprenant un dispositif de ralentissement (R) destiné à freiner les corpuscules (PE), caractérisé en ce que le dispositif de ralentissement (R) est disposé a l'intérieur du dispositif optique pour corpuscules et l'appareil comprend des moyens d'alimentation du dispositif de ralentissement (R) à un potentiel tel que les corpuscules (PE) sont freinés de manière à passer d'une première énergie comprise dans la plage allant de 2 à 50 keV à une seconde énergie moins forte, comprise dans la plage allant de 0,5 à 20 keV.

2. Appareil à rayonnement corpusculaire selon la revendication 1, caractérisé en ce que la lentille de condenseur (K1,K2) est une lentille magnétique.

3. Appareil à rayonnement corpusculaire selon la revendication 1 ou 2, caractérisé en ce que le dispositif de ralentissement (R) est disposé entre une première lentille (K1) et une seconde lentille (K2) de condenseur.

4. Appareil à rayonnement corpusculaire selon l'une des revendications 1 et 2, caractérisé en ce que le dispositif de ralentissement (R) est disposé entre une lentille de condenseur (K1,K2) et la lentille de l'objectif (OB).

5. Appareil à rayonnement corpusculaire selon l'une des revendications 1 à 4 caractérisé en ce que le dispositif de ralentissement (R) est disposé en un point de convergence du faisceau.

6. Appareil à rayonnement corpusculaire selon l'une des revendications 1 et 2, caractérisé en ce que le dispositif de ralentissement (R) est disposé à l'intérieur de la lentille de l'objectif (OB).

7. Appareil à rayonnement corpusculaire selon la revendication 1 ou 2, caractérisé en ce que le dispositif de ralentissement (R) est disposé à l'intérieur d'une lentille de condenseur (K1,K2).

8. Appareil à rayonnement corpusculaire selon l'une des revendications 1 à 7, caractérisé par un système d'effacement disposé en un point de convergence du faisceau.

9. Appareil à rayonnement corpusculaire selon la revendication 8, caractérisé en ce que le système d'effacement est disposé dans la marche du faisceau derrière le dispositif de ralentissement (R).

10. Appareil à rayonnement corpusculaire selon l'une des revendications 1 à 9, caractérisé en ce que la lentille de l'objectif (OB) est constituée d'une lentille électrique symétrique (E).

11. Appareil à rayonnement corpusculaire selon l'une des revendications 1 à 10, caractérisé par un cylindre creux qui est au potentiel de l'anode (A) du générateur de faisceau de corpuscules et qui est disposé entre le générateur de faisceau de corpuscules et le dispositif de ralentissement (R), coaxialement à l'axe du faisceau.

12. Appareil à rayonnement corpusculaire selon la revendication 11, caractérisé en ce que le cylindre creux est en matériau non ferromagnétique.

13. Appareil à rayonnement corpusculaire selon l'une des revendications 1 à 5, caractérisé en ce que le générateur de faisceau de corpuscules (K,W,A) comprend une cathode émettrice par effet de champ (K) et en ce que le dispositif de ralentissement (R) est disposé sur la marche du faisceau au-dessus de la lentille de l'objectif (OB).

14. Appareil à rayonnement corpusculaire selon l'une des revendications 1 à 13, caractérisé par un dispositif de ralentissement électrostatique (R).

15. Appareil à rayonnement corpusculaire selon l'une des revendication 1 à 14, caractérisé en ce que le dispositif de ralentissement (R) est constitué d'un montage à plusieurs électrodes (E).

16. Appareil à rayonnement corpusculaire selon la revendication 15, caractérisé en ce que le dispositif de ralentissement (R) est constitué d'un montage à deux électrodes (1,2,3).

17. Appareil à rayonnement corpusculaire selon l'une des revendications 1 à 14, caractérisé en ce que le dispositif de ralentissement (R) est une électrode réticulaire (N).

18. Appareil à rayonnement corpusculaire selon l'une des revendications 1 à 14, caractérisé en ce que le dispositif de ralentissement (R) est un diaphragme (B).

19. Appareil à rayonnement corpusculaire selon l'une des revendications 1 à 14, caractérisé en ce que le dispositif de ralentissement (R) est une lentille tubulaire (RO).

20. Appareil à rayonnement corpusculaire selon l'une des revendications 1 à 15, caractérisé en ce que le dispositif de ralentissement (R) est une lentille symétrique (E).

21. Utilisation d'un appareil à rayonnement corpusculaire selon l'une des revendications 1 à 20 en appareil de mesure à faisceau corpusculaire.

22. Utilisation d'un appareil à rayonnement corpusculaire selon l'une des revendications 1 à 20 en imprimante à faisceau corpusculaire.

23. Utilisation d'un appareil à rayonnement corpusculaire selon l'une des revendications 1 à 20 en appareil de mesure de longueur.

# FIG 1

FIG 2

K
W
A

K1

PE

K2

R

D

OB

DT

SE

PR

FIG 3

K
W
A

K1

PE

K2

R

D

OB

DT

SE

PR

FIG 4

K
W
A

K1

R

PE

K2

D

OB

SE

DT

PR

FIG 5

K
W
A

K1

PE

K2

R'

D

E

SE
PR

DT

# FIG 6